# EUROPEAN PATENT APPLICATION

(11) **EP 4 365 943 A1**
(43) Date of publication of application: **08.05.2024**
(21) Application number: 23207486.4
(22) Date of filing: 02.11.2023
(51) Int. Cl.: H01L 23/495

(54) **METHOD OF MANUFACTURING SEMICONDUCTOR DEVICES, CORRESPONDING COMPONENT, SEMICONDUCTOR DEVICE AND METHOD**

(30) Priority: 02.11.2022 IT 202200022431
(71) Applicant: STMicroelectronics S.r.l., 20864 Agrate Brianza (MB) (IT)
(72) Inventor: MAZZOLA, Mr. Mauro, I-24040 Calvenzano (Bergamo) (IT)
(74) Representative: Bosotti, Luciano

(57) **Abstract**

A semiconductor die (14) is arranged on a die pad (12A) in leadframe (12) and electrically coupled with one or more electrically conductive leads (12B) in the leadframe (12) arranged peripherally of the leadframe (12) with an electrical coupling member (clip block, 100) applied onto the semiconductor die (14) arranged on the leadframe (12).

The electrical coupling member (100) comprises a planar body (24, 102, 104) configured to cover the semiconductor die (14) as well as the electrically conductive lead or leads (12B). The planar body of the electrical coupling member (100) comprises electrically insulating material (24) having embedded therein at least one strip-like, electrically conductive formation (102, 104) having a first end (102) configured to contact (SM) the semiconductor die (14) as well as a second end (104) configured to contact (SM) the electrically conductive lead or leads (12B).

## Description

### Technical field

The description relates to manufacturing semiconductor devices.

Solutions as described herein can be applied to power semiconductor devices such as power QFN packages, for automotive products, for instance.

### Background

In power semiconductor devices, the current transferred from the high-power section to the output pads of the device can be significant. Clips are used for that purpose in the place of wires.

Clips are currently stamped from flat material. Pins are also created extruding the material by punching with the purpose of centering the clip on the leadframe. Recesses are created at corresponding leadframe positions to house the clip pins for centering purposes.

In small power QFNs and/or if several channels are desired in the final package, more pads are needed and the dimensions for recesses on leadframe and clips may become relatively small.

Clips are tighter and pins may reach critical dimensions to be made by stamping as the punch may be too fragile to stamp material.

Furthermore, clips singulation and handling may become difficult due to tighter and elongated clips shape.

### Object and summary

Solutions as described herein aim at addressing the issues discussed in the foregoing.

Such an object can be achieved via a method having the features set forth in the claims that follow.

One or more embodiments relate to a corresponding component. An electrical coupling member (clip block) for use in manufacturing (e.g., power) semiconductor devices and suited to be provided by a supplier to a manufacturer of semiconductor devices can be exemplary of such a component.

One or more embodiments relate to a semiconductor device comprising such a component.

One or more embodiments relate to a method of manufacturing such a component.

The claims are an integral part of the technical teaching provided in respect of the embodiments.

In solutions as described herein, a clip block (single or multiple) is formed with a featured volume using premolding technology.

In solutions as described herein, a clip with determined shape is formed starting from metallic (e.g., copper) material via photoetching technology.

Solutions as described herein contemplate providing a leadframe, mounting a die thereon, forming electrical connections between the die and leads in the leadframe through clip bonding.

### Brief description of the several views of the drawings

One or more embodiments will now be described, by way of example only, with reference to the annexed figures, wherein:
Figures 1 and 2 are plan views illustrative of the structure of a power semiconductor device,
Figure 3 is illustrative of a clip manufacturing method,
Figure 4 is a cross-sectional view along line IV-IV of Figure 2,
Figures 5 and 6 are opposed plan views of the result of a first step in manufacturing a clip block as described in the present description,
Figure 7 is a cross-sectional view along line VII-VII of Figure 5,
Figure 8 is a plan (bottom) view of the result of a further step in manufacturing a clip block as described in the present description,
Figure 9 is a cross-sectional view along line IX-IX of Figure 8,
Figure 10 is illustrative of a clip block as described herein, mounted on a semiconductor device,
Figure 11 is a cross-sectional view along line XI-XI if Figure 10,
Figures 12 and 13 are opposed plan views of a variant of a clip block as described herein,
Figure 14 is a cross-sectional view along line XIV-XIV of Figure 12,
Figure 15 is a plan view illustrative of a clip block as illustrated in Figure 14 mounted on a semiconductor device, and
Figure 16 is a cross-sectional view along line XVI-XVI of Figure 15.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

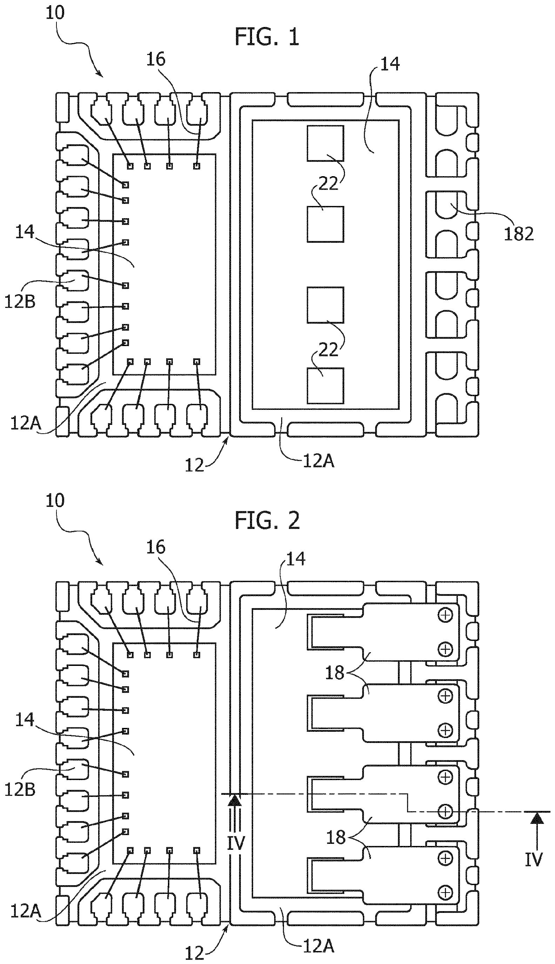

Figures 1 and 2 illustrate the structure of a power semiconductor device 10 comprising a low-power section (illustrated on the left-hand side of both Figures 1 and 2) e.g., a controller die or chip, attached on a first die pad 12A in a leadframe 12 and a high-power section (illustrated on the right-hand side of Figures 1 and 2) e.g., one or more power dice or chips attached on one or more die pads 12A in the lead frame 12.

An array of leads 12B is arranged around the die pads 12A having the low-power and the high-power dice mounted thereon.

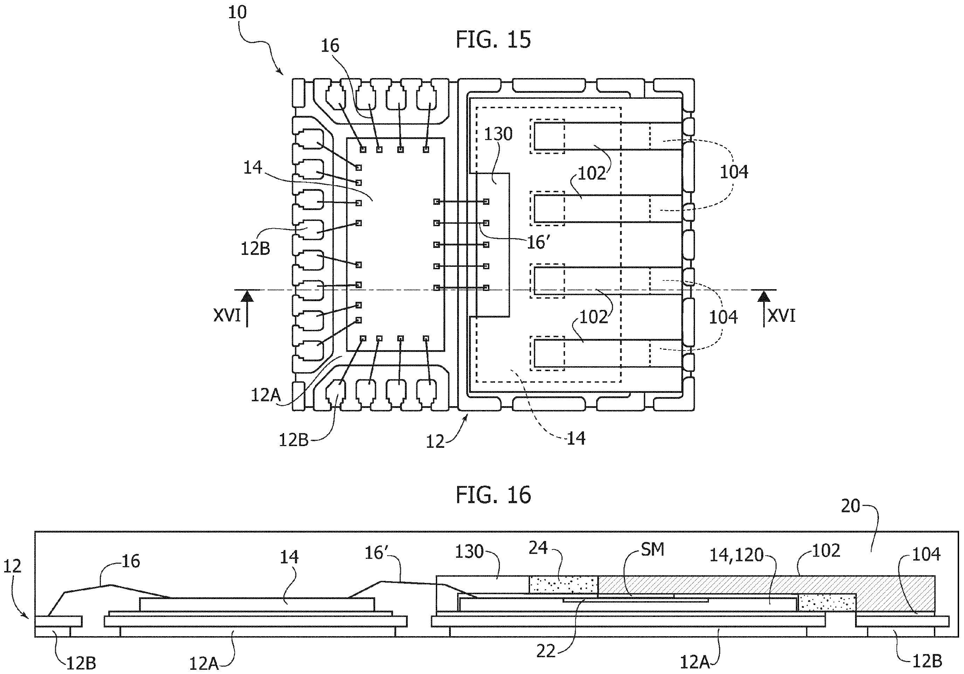

As illustrated herein by way of example, a semiconductor device such as the device 10 comprises, in addition to a substrate (leadframe) 12 having one or more semiconductor chips or dice 14 (as used herein, the terms chip/s and die/dice are regarded as synonymous) arranged thereon:
electrically conductive formations (wires, ribbons, clips) 16, 18 coupling the semiconductor chip(s) 14 to leads (outer pads) 12B in the substrate, and
an insulating encapsulation (e.g., a resin, visible only in Figure 16 and designated there with reference 20) molded on the assembly thus formed to complete the plastic body of the device 10.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

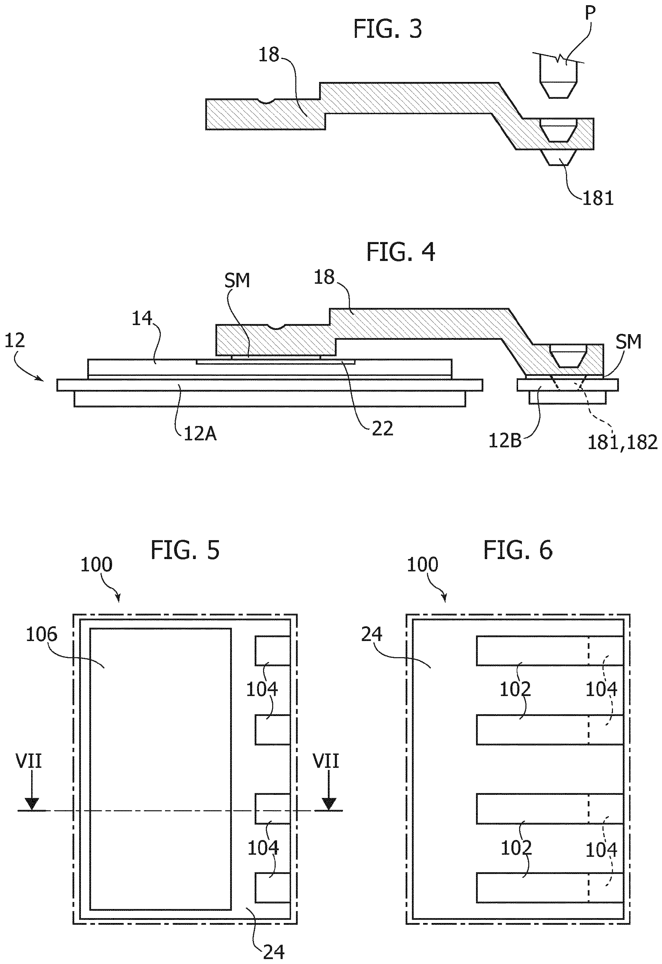

Essentially, a leadframe 12 comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A in Figure 4) configured to have at least one semiconductor chip or die attached thereon. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by a resin "pre-molded" on the sculptured metal structure.

The current transferred from the high-power section to the output pads 12B of the device can be significant. As shown on the right-hand side of Figure 2, clips 18 are thus used for that purpose in the place of wires. Wires 16 can still be used, as shown on the left-hand side of Figure 2, to provide electrical coupling to a low-power section (e.g., a controller) in the device.

That is, as illustrated in Figures 1 and 2, electrically conductive formations are provided comprising wire bonding patterns 16 coupling the low-power section (left-hand side of Figures 1 and 2, for instance) to selected ones of the leads 12B. These wire bonding patterns are coupled to die pads provided at the front or top surfaces of the chips (not visible in the figures).

Conversely, clips are used to couple the high-power section (right-hand side of Figure 2) to selected ones of the leads 12B acting as (power) output pads of the device 10. Using clips in the place of wires accounts for the fact that the current transferred from the high-power section to the output pads in a power semiconductor device may be significant.

According to a conventional approach, clips 18 as illustrated, for instance, in Figure 3, are formed by stamping flat metallic (e.g., copper) material. Pins 181 are also formed (by punching, P) in the terminal part of the clip (on the right in Figure 3) which will be coupled to the lead 12.

The pins 181 and corresponding recessed portions 182 (as illustrated in Figure 1) of the leads 12B in the leadframe 12 facilitate clip centering when mounting the clip on the leadframe-chip assembly.

The cross-sectional view of Figure 4 illustrates how a clip 18 as shown in Figure 3 can be included in the high-power section of a semiconductor device as illustrated in Figure 2 so that the clip 18 can provide electrical coupling between the chip or die 14 and one of the leads 12B.

The distal end (on the right side in Figure 4) of the clip 18 is positioned with the pin 181 inserted in the recessed portion 182 of the lead 12B. Solder material SM is used to form the electrical connection therebetween.

The proximal end (on the left side in Figure 4) of the clip 18 is soldered (via solder material, SM) to the front or top surface of the chip 14.

A device structure as discussed so far is conventional in the art, which makes it unnecessary to provide a more detailed description herein.

As noted, when manufacturing small sized power devices or when several electrical channels are involved, the conventional method just described for providing electrical coupling to the power section of the device via clips may be faced with various difficulties.

For instance, the little room available suggests that smaller clips 18 (and consequently smaller pins 181 and recesses 182) are used. The pin dimensions may become critical to be formed by stamping, as the punch may become too fragile to stamp material.

Moreover, clip singulation (clips are usually supplied as a strip or chain of connected clips) and handling may be difficult as a consequence of the elongated shape and relatively small size of the clips.

A way to address that problem may involve improving clip stamping technology and machining or choosing a different clip material.

However, these methods have the disadvantage of increasing production costs and, additionally, a different material for the clips may result in a degradation of the electrical performances of the device.

Another possible way to address the problem may involve increasing package size, thus imposing constraints on device design.

Solutions as described herein address these issues by forming one or multiple electrical coupling members ("clip blocks") using premolding technology.

In solutions as described herein a photoetching process can be advantageously applied to clip block manufacturing.

For simplicity and ease of explanation, the case will be considered in the following description of a clip block 100 with four high-current electrical couplings, that is four clips. This is by way of example only, as any number (notionally 1 to N) or a different layout of couplings may be suggested by device design.

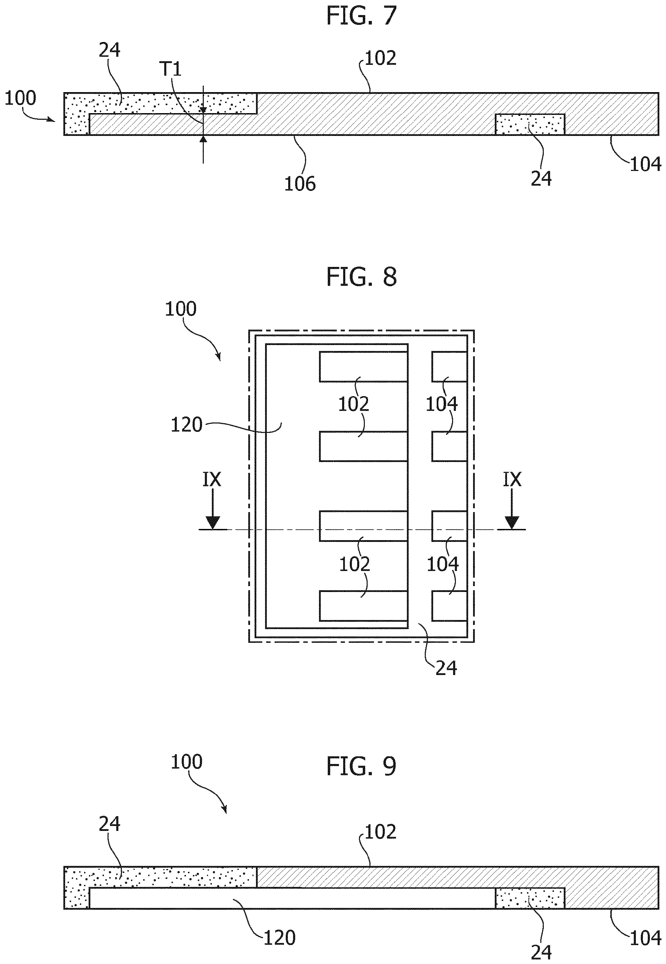

Figures 5 and 6 are plan views of the back (bottom) and front (top) surfaces respectively of a clip block 100, while Figure 7 is a cross-sectional view of the clip block 100 along line VII-VII of Figures 5.

Such a clip block 100 can be advantageously formed via premolding processing technology, similarly to the processing of a pre-molded leadframe.

In that process, a metal (e.g., copper) sheet is processed via a first (photo) etching step to form a sculptured structure comprising empty spaces that are filled with a resin "pre-molded" on the sculptured metal structure. A second (photo)etching step may be performed to etch away additional metallic material, thus forming additional features in the sculptured structure.

Plural blocks 100 (as illustrated, for instance, in Figures 5 to 7), may be manufactured concurrently and later separated into single individual clip blocks in a final "singulation" step.

For simplicity and ease of explanation, the following description will refer to manufacturing a single clip block 100.

As illustrated herein, the electrical coupling member (clip block) 100 comprises a planar body configured (that is sized and dimensioned) to cover a semiconductor die 14 arranged on a die mounting location such as the die pad 12A of the die mounting substrate (leadframe) 12 as well as the electrically conductive leads 12B arranged peripherally of the leadframe 12 and intended to be electrically coupled to the (power) semiconductor die 14.

The planar body of the clip block 100 comprises electrically insulating material 24 (an epoxy resin, for instance) having embedded therein one or more strip-like, electrically conductive formations (e.g., metal, like copper).

The strip-like, electrically conductive formation or formations have a (finger-like) first end 102 configured to contact the semiconductor die 14 arranged on the die pad 12A as well as a second end (tip) 104 configured to contact the electrically conductive lead or leads 12B.

Figure 5 illustrates the back or bottom surface of such a "pre-molded" clip block 100.

Two portions of the bottom surface may be identified:
a portion of metallic material (e.g., copper) corresponding to four "tips" 104 and a larger area 106 and
a portion of pre-molding resin 24 penetrated between the tips 104 and the area 106.

It is noted that the number of tips 104 (four in this case) and/or the shape of the area 106 as illustrated herein are merely by way of example: a different number of connections (e.g., embedded side-by-side in the material 24) or a different coupling layout can be provided, depending on device design.

Figure 6 illustrates the top surface of the clip block 100. In this case the metallic material (copper) is again visible in the (four, in this example) finger regions, indicated as 102, each finger 102 having one of the tips 104 as a distal portion.

The cross-sectional view of Figure 7 further illustrates the features of the clip block 100.

It is observed that the metallic material (e.g., copper) extends from the back bottom to the front or top surface of the clip block 100 above the tips 104 and part of the area of the bottom surface of the clip block, while at the terminal part of the region 106 (on the left in Figure 7) the metallic material has a reduced thickness T1 at the bottom surface of the clip block.

A clip block 100 as illustrated herein can thus be manufactured (possibly as a component to be supplied by a supplier to a manufacturer of semiconductor devices) by first providing a sculptured, electrically conductive planar structure including the strip-like, electrically conductive formation or formations 102, 104, and then molding insulating material 24 onto the sculptured, electrically conductive planar structure to fill the empty spaces therein. As a result of the material 24 filling such empty spaces, a planar body of the clip block 100 if formed comprising the electrically insulating material 24 having embedded therein the strip-like, electrically conductive formation or formations 102, 104.

Figures 5 to 7 are exemplary a first phase of manufacturing a clip block 100.

As noted, that phase may include a sequence of steps that are per se conventional in manufacturing "pre-molded" leadframes, namely:
forming (e.g., via etching a metal strip) a sculptured (e.g., the fingers 102 and the tips 104) having empty spaces therein, and
molding insulating material (e.g., an epoxy resin) onto that structure and fill the empty spaces therein, the resulting resin-molded structure having the same thickness of the electrically conductive sculptured structure.

Figures 8 and 9 illustrate another possible step in manufacturing a clip block 100 as discussed herein.

Figure 8 is a bottom view of a clip block 100 as in Figure 5 where the metallic material of the region indicated as 106 has been partially removed (e.g., etched) for the thickness T1 in Figure 5.

As a result of the region 106 being (partially) etched, the clip block 100 has now a hollow volume 120 in the bottom surface with the fingers 102 exposed at that hollow volume 120.

This can be appreciated in the cross-sectional view of Figure 9, while the top or front view of Figure 6 still applies also after formation of the hollow volume 120: in fact, the top of front surface of the clip block is not affected by that step.

The cross-sectional view in Figure 9 shows metallic material in the area 106 being partially removed (via, e.g., photoetching) starting from the bottom surface of the clip block, for a thickness T1, exposing the fingers 102 the clips. The hollow volume 120 thus formed can facilitate the centering of the clip block 100 on the die, as it may be shaped in such a way to accommodate (house) the chip.

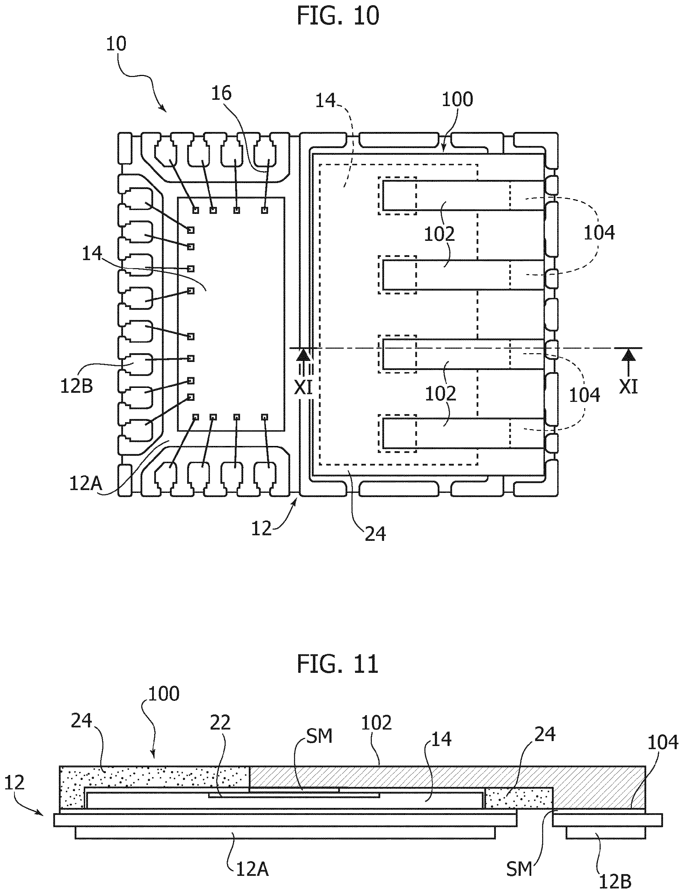

Figures 10 and 11 are exemplary of a clip block 100 mounted on the power section of a semiconductor device 10 as illustrated in Figures 1 and 2 with the clip block 100 replacing the clips 18 visible on the right-hand side of Figure 2.

Figure 11 shows that the fingers 102 and the tips 104 can be soldered (as indicated by SM) to the (die pads 22 of the) chip or die 14 and the leads 12B, thus providing electrical couplings between the chip or die 14 and the leads 12B.

As illustrated, the hollow volume 120 may be shaped in a way to accommodate (house) the chip 14, thus facilitating the centering of the clip block 100 on the chip 14.

Again (as in Figures 1 and 2) wires 16 can be used to provide electrical connection to the low-power section of the device.

In certain devices wires, such as those indicated by 16' in Figures 15 and 16, can be used (also) to provide electrical coupling between the low-power and the high-power sections of the device.

A clip block 100 as discussed so far can be modified to accommodate (also) such wires 16'.

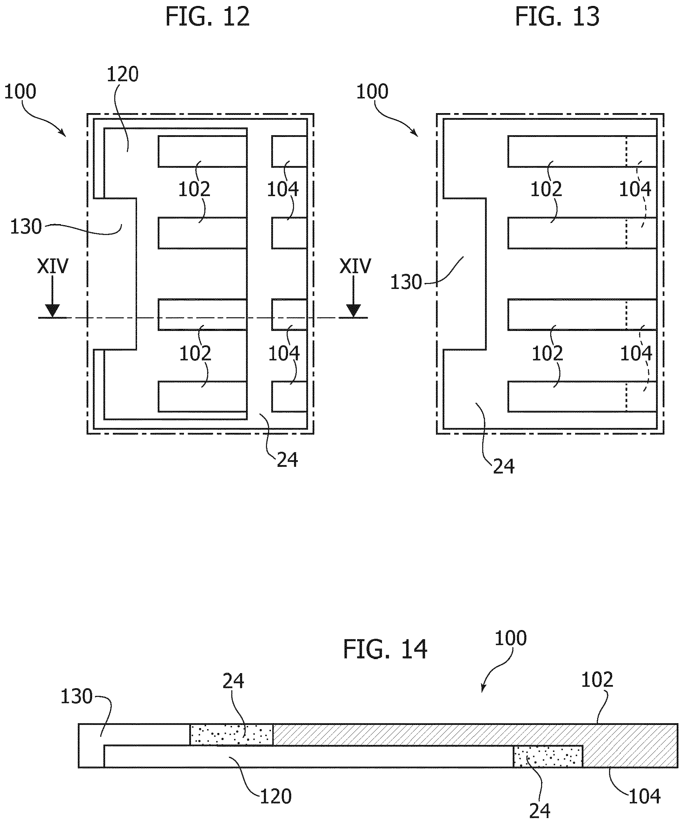

For instance (as illustrated in Figures 12 to 14, again a bottom, top and cross-sectional view of such a modified clip block 100) the block 100 can be formed with a cut out portion 130 to leave the high-power chip exposed to provide a landing area for wires 16' coupling the high-power section to the low-power section.

The recess 130 can be formed, e.g., by initially leaving metal at a corresponding location when forming (e.g., first etching) the electrically conductive sculptured metal structure of the block 100 so that no resin will penetrate at that location. That metal can be removed during subsequent etching that leads to the formation of a hollow volume 120, thus leading to the formation of an additional empty space such as the cut out 130.

The position of the cut out 130 can be adequately chosen to match the position of the die bonding pads 22 on the upper surface of the die 14.

The position of the cut out 130 of the clip block 100 as illustrated in the figures is merely exemplary: a different implementation of the device design may require a different position or shape for the cut out 130.

Figures 15 and 16 are respectively a plan view and a cross-sectional view of a semiconductor device comprising a clip block 100 as just described.

As illustrated, the cut out 130 in the clip block 100 leaves a portion of the surface of the power chip exposed and the die pads thereon available for the electrical coupling (via wires 16') to the control chip.

The device as illustrated in Figure 16 includes a protective resin encapsulation 20 molded onto the assembly described in the foregoing to complete the plastic body of the device package.

Without prejudice to the underlying principles, the details and embodiments may vary, even significantly, with respect to what has been described by way of example only without departing from the extent of protection. The extent of protection is determined by the annexed claims.

## Claims

1. A method, comprising:
arranging at least one semiconductor die (14) on a die mounting location (12A) of a die mounting substrate (12),
electrically coupling the at least one semiconductor die (14) with at least one electrically conductive lead (12B) of the die mounting substrate (12), the at least one electrically conductive lead (12B) arranged peripherally of the die mounting substrate (12),
wherein said electrically coupling comprises applying onto the at least one semiconductor die (14) arranged on the die mounting location (12A) of the die mounting substrate (12) an electrical coupling member (100), wherein:
the electrical coupling member (100) comprises a planar body (24, 102, 104) configured to cover the at least one semiconductor die (14) arranged on the die mounting location (12A) of the die mounting substrate (12) as well as the at least one electrically conductive lead (12B) arranged peripherally of the die mounting substrate (12), and
the planar body of the electrical coupling member (100) comprises electrically insulating material (24) having embedded therein at least one strip-like, electrically conductive formation (102, 104) having a first end (102) configured to contact (SM) the at least one semiconductor die (14) arranged on the die mounting location (12A) as well as a second end (104) configured to contact (SM) the at least one electrically conductive lead (12B).

2. The method of claim 1, wherein the planar body of the electrical coupling member (100) comprises a plurality of said strip-like, electrically conductive formations (102, 104) embedded side-by-side in said electrically insulating material (24).

3. The method of claim 1 or claim 2, wherein the electrical coupling member (100) comprises a portion of reduced thickness forming a recessed portion (120) of the planar body of the electrical coupling member (100) and the method comprises applying the electrical connection member (100) onto the at least one semiconductor die (14) arranged on the die mounting location (12A) of the die mounting substrate (12) with the at least one semiconductor die (14) housed in the recessed portion of the planar body of the electrical coupling member (100).

4. The method of any of the previous claims, wherein the electrical connection member (100) comprises a cut out portion (130) configured to leave uncovered a respective area of the at least one semiconductor die (14) and the method comprising landing electrically conductive wires (16') at said respective area of the at least one semiconductor die (14).

5. An electrical coupling member (100) configured to electrically couple at least one semiconductor die (14) arranged on a die mounting location (12A) of a die mounting substrate (12) with at least one electrically conductive lead (12B) arranged peripherally of the die mounting substrate (12A), wherein:
the electrical coupling member (100) comprises a planar body (24, 102, 104) configured to cover the at least one semiconductor die (14) arranged on the die mounting location (12A) of the die mounting substrate (12) as well as the at least one electrically conductive lead (12B) arranged peripherally of the die mounting substrate (12), and
the planar body of the electrical coupling member (100) comprises electrically insulating material (24) having embedded therein at least one strip-like, electrically conductive formation (102, 104) having a first end (102) configured to contact (SM) the at least one semiconductor die (14) arranged on the die mounting location (12A) as well as a second end (104) configured to contact (SM) the at least one electrically conductive lead (12B).

6. The electrical coupling member (100) of claim 5, wherein the planar body of the electrical coupling member (100) comprises a plurality of said strip-like, electrically conductive formations (102, 104) embedded side-by-side in said electrically insulating material (24) .

7. The electrical coupling member (100) of claim 5 or claim 6, wherein the electrical coupling member (100) comprises a portion of reduced thickness providing a recessed portion (120) of the planar body of the electrical coupling member (100) configured to house said at least one semiconductor die (14).

8. The electrical coupling member (100) of any of claims 5 to 7, the electrical coupling member (100) having a cut out portion (130) configured to leave uncovered a respective area of the at least one semiconductor die (14) configured to land electrically conductive wires (16') thereon.

9. A device, comprising:
at least one semiconductor die (14) arranged a die mounting location (12A) of a die mounting substrate (12) with at least one electrically conductive lead (12B) arranged peripherally of the die mounting substrate (12), and
at least one electrical coupling member (100) according to any of claim 5 to 8 applied onto the at least one semiconductor die (14) arranged on the die mounting location (12A) of the die mounting substrate (12) and electrically coupling the at least one semiconductor die (14) with at least one electrically conductive lead (12B) of the die mounting substrate (12) .

10. A method of manufacturing an electrical coupling member (100) according to any of claims 5 to 8, the method comprising:
providing a sculptured, electrically conductive planar structure including said at least one strip-like, electrically conductive formation (102, 104), and
and
molding insulating material (24) onto said sculptured, electrically conductive planar structure to provide a planar body of the electrical coupling member (100) comprising said electrically insulating material (24) having embedded therein said least one strip-like, electrically conductive formation (102, 104).

11. The method of claim 10 applied to manufacturing an electrical coupling member (100) according to claim 7, the method comprising forming in said planar body of the electrical coupling member (100) comprising said electrically insulating material (24) having embedded therein said least one strip-like, electrically conductive formation (102, 104) a portion of reduced thickness providing a recessed portion (120) of the planar body of the electrical coupling member (100) configured to house said at least one semiconductor die (14) .

12. The method of claim 10 applied to manufacturing an electrical coupling member (100) according to claim 8, the method comprising forming in said planar body of the electrical coupling member (100) comprising said electrically insulating material (24) having embedded therein said least one strip-like, electrically conductive formation (102, 104) a cut out portion (130) configured to leave uncovered a respective area of the at least one semiconductor die (14) to land electrically conductive wires (16') thereon.
